# EUROPÄISCHE PATENTANMELDUNG

(11) **EP 4 109 116 A1**
(43) Veröffentlichungstag der Anmeldung: **28.12.2022**
(21) Anmeldenummer: 22020059.6
(22) Anmeldetag: 17.02.2022
(51) Int. Cl.: G01R 19/00, H01B 7/42, B60L 53/14, G01R 1/20, G01R 19/32

(54) **MESSANORDNUNG**

(30) Priorität: 21.06.2021 DE 102021115990
(71) Anmelder: Dr. Ing. h.c. F. Porsche Aktiengesellschaft, 70435 Stuttgart (DE)
(72) Erfinder: Fuchs, Patrick, 71229 Leonberg (DE); Barkow, Maximilian, 70469 Stuttgart (DE); Velic, Timijan, 71287 Weissach (DE); Wachter, Sebastian, 96332 Pressig (DE)

(57) **Zusammenfassung**

Eine Messanordnung (20) weist eine Stromleitung (40), eine erste Messstelle (51), eine zweite Messstelle (52) und ein Kühlmittel (80) auf, welche erste Messstelle (51) an der Stromleitung (40) vorgesehen ist, welche zweite Messstelle (52) an der Stromleitung (40) vorgesehen ist und von der ersten Messstelle (51) beabstandet ist, um eine Spannungsmessung der durch den durch die Stromleitung (40) fließenden Strom (I) entstehenden Spannung in einem Messabschnitt (41) der Stromleitung (40) zu ermöglichen, welcher Messabschnitt (41) zwischen der ersten Messstelle (51) und der zweiten Messstelle (52) definiert ist, und welches Kühlmittel (80) fluidförmig ist und zumindest bereichsweise in direktem Kontakt zur Stromleitung (40) im Bereich zwischen der ersten Messstelle (51) und der zweiten Messstelle (52) steht.

## Beschreibung

Die Erfindung betrifft eine Messanordnung, eine Elektronikschaltung und ein Fahrzeug.

Die DE 10 2004 018 469 B3 zeigt eine Leistungshalbleiterschaltung mit einem flachen Halbleitermodul, welches direkt auf einer Deckschiene einer stromführenden Verschienung angeordnet ist, wobei eine Kühleinrichtung in die Verschienung integriert ist.

Die DE 10 2016 200 724 A1 zeigt eine Vorrichtung zur Kühlung einer Stromschiene mit einem Grundkörper und mindestens einer Kühlrippe und eine Leistungsschaltung

Es ist daher eine Aufgabe der Erfindung, eine neue Messanordnung, eine neue Elektronikschaltung und ein neues Fahrzeug bereit zu stellen.

Die Aufgabe wird gelöst durch die Gegenstände der unabhängigen Patentansprüche.

Eine Messanordnung weist eine Stromleitung, eine erste Messstelle, eine zweite Messstelle und ein Kühlmittel auf, welche erste Messstelle an der Stromleitung vorgesehen ist, welche zweite Messstelle an der Stromleitung vorgesehen ist und von der ersten Messstelle beabstandet ist, um eine Spannungsmessung der durch den durch die Stromleitung fließenden Strom entstehenden Spannung in einem Messabschnitt der Stromleitung zu ermöglichen, welcher Messabschnitt zwischen der ersten Messstelle und der zweiten Messstelle definiert ist, und welches Kühlmittel fluidförmig ist und zumindest bereichsweise in direktem Kontakt zur Stromleitung im Bereich zwischen der ersten Messstelle und der zweiten Messstelle steht. Das Kühlmittel ermöglicht eine gute Kühlung der Stromleitung im Abschnitt der Messstelle und damit eine geringe Beeinflussung der Messung durch Temperatureffekte. So ist beispielsweise der spezifische elektrische Widerstand bei vielen Materialien temperaturabhängig. Insbesondere bei hohen Strömen in der Stromleitung ist eine Kühlung vorteilhaft.

Gemäß einer bevorzugten Ausführungsform weist die Stromleitung im Messabschnitt einen größeren elektrischen Widerstand auf als in mindestens einem ersten Stromleitungsabschnitt außerhalb des Messabschnitts, welcher erste Stromleitungsabschnitt die gleiche Länge entlang der Stromleitung hat wie der Messabschnitt. Durch den größeren elektrischen Widerstand im Messabschnitt fällt eine größere Spannung durch den in der Stromleitung fließenden Strom ab, und dies erhöhte die Messgenauigkeit.

Gemäß einer bevorzugten Ausführungsform weist die Stromleitung im Messabschnitt zumindest abschnittsweise eine geringere Querschnittsfläche auf als in dem mindestens einen ersten Stromleitungsabschnitt. Durch die geringere Querschnittsfläche erhöhen sich der elektrische Widerstand im Messabschnitt und damit die Messgenauigkeit.

Gemäß einer bevorzugten Ausführungsform weist die Stromleitung im Messabschnitt zumindest abschnittsweise ein erstes Material auf und in dem mindestens einen ersten Stromleitungsabschnitt zumindest abschnittsweise ein zweites Material auf, welches erste Material einen höheren spezifischen elektrischen Widerstand aufweist als das zweite Material. Durch diese Maßnahme wird der elektrische Widerstand im Bereich des Messabschnitts größer als bei Verwendung des ersten Materials, und dies erhöht die Messgenauigkeit.

Gemäß einer bevorzugten Ausführungsform weist die Stromleitung im Messabschnitt zumindest abschnittsweise die gleiche Querschnittsfläche und das gleiche Material auf wie in mindestens einem zweiten Stromleitungsabschnitt außerhalb des Messabschnitts. Dies erleichtert die Herstellung, und bei hohen Strömen I kann die normale Stromleitung zur Messung im Messabschnitt genutzt werden.

Gemäß einer bevorzugten Ausführungsform weist die Messanordnung einen Kühlmittelkanal mit einer Kühlmittelkanalwand auf, wobei im Kühlmittelkanal das Kühlmittel vorgesehen ist, und wobei der Messabschnitt der Stromleitung zumindest abschnittsweise im Kühlmittelkanal angeordnet ist. Die Verwendung eines Kühlmittelkanals ermöglicht die Erzeugung eines Kühlmittelflusses im Kühlmittelkanal, beispielsweise durch Verwendung einer Kühlmittelpumpe.

Gemäß einer bevorzugten Ausführungsform ist die Stromleitung zumindest abschnittsweise außerhalb des Messabschnitts im Kühlmittelkanal angeordnet. Die Kühlung der Stromleitung außerhalb des Messabschnitts verringert den elektrischen Widerstand in der Stromleitung und damit die Verlustleistung durch den Stromfluss durch die Stromleitung.

Gemäß einer bevorzugten Ausführungsform sind die erste Messstelle mit einer ersten Signalleitung verbunden und die zweite Messstelle mit einer zweiten Signalleitung verbunden, und die erste Signalleitung und die zweite Signalleitung erstrecken sich an mindestens einer ersten Durchtrittsstelle durch die Kühlmittelkanalwand hindurch, wobei mindestens ein erstes Abdichtelement zur Abdichtung der mindestens einen ersten Durchtrittsstelle vorgesehen ist. Durch diese Ausgestaltung kann die weitere Signalauswertung auf der Außenseite des Kühlmittelkanals und damit im Trockenbereich erfolgen.

Gemäß einer bevorzugten Ausführungsform weist die Messanordnung eine Signalverarbeitungseinrichtung auf, welche Signalverarbeitungseinrichtung mit der ersten Messstelle und mit der zweiten Messstelle elektrisch verbunden ist, welche Signalverarbeitungsvorrichtung sich zumindest abschnittsweise im Kühlmittelkanal befindet. Diese Ausgestaltung ermöglicht kurze elektrische Verbindungen zwischen den Messstellen und der Signalverarbeitungseinrichtung und damit eine Reduzierung von Störstrahlungen in die elektrischen Verbindungsleitungen.

Gemäß einer bevorzugten Ausführungsform umfasst die Signalverarbeitungseinrichtung mindestens ein Schaltungselement aus der Schaltungselementgruppe bestehend aus
- Verstärker,
- Analog-/Digitalwandler,
- Übertragungsmodul für eine drahtlose Datenübertragung, und
- Spannungsteiler.

Verstärker sind vorteilhaft für die Messgenauigkeit bei kleinen Signalen. Analog-/Digitalwandler erleichtern die Weiterverarbeitung in einer Steuervorrichtung. Ein Übertragungsmodul für eine drahtlose Datenübertragung ermöglicht (ausschließlich oder ggf. zusätzlich) eine Datenübertragung von der Innenseite des Kühlmittelkanals zur Außenseite und erleichtert damit die Abdichtung.

Gemäß einer bevorzugten Ausführungsform erstreckt sich mindestens eine dritte Signalleitung von der Signalverarbeitungseinrichtung an mindestens einer zweiten Durchtrittsstelle durch die Kühlmittelkanalwand hindurch, wobei mindestens ein zweites Abdichtelement zur Abdichtung der mindestens einen zweiten Durchtrittsstelle vorgesehen ist. Bei der Verwendung einer Glasfaserleitung ist beispielsweise eine einzige dritte Signalleitung ausreichend. Es können aber auch mehrere elektrische Leitungen oder auch mehrere Glasfaserleitungen vorgesehen sein.

Gemäß einer bevorzugten Ausführungsform ist die Messanordnung zur Messung eines Stroms in der Stromleitung mit einer maximalen Stromstärke eingerichtet, welche maximale Stromstärke mindestens 10 A beträgt, bevorzugt mindestens 50 A beträgt und besonders bevorzugt mindestens 80 A beträgt. Die Messanordnung ermöglicht also auch die Messung hoher Ströme und ist für leistungsstarke Leistungselektronik geeignet.

Gemäß einer bevorzugten Ausführungsform sind in dem Kühlmittelkanal mindestens zwei Stromleitungen vorgesehen, welche jeweils einen Messabschnitt mit einer ersten Messstelle und einer zweiten Messstelle aufweisen.

Eine Elektronikschaltung weist mindestens eine solche Messanordnung auf, und sie weist bevorzugt mindestens drei solche Messanordnungen auf. Eine solche Elektronikschaltung ermöglicht eine sehr genaue Messung der Ströme, und sie kann daher vergleichsweise genau arbeiten.

Gemäß einer bevorzugten Ausführungsform weist die Elektronikschaltung mindestens eine erste Elektronikschaltung auf aus der Elektronikschaltungsgruppe bestehend aus:
- AC/DC-Wandler,
- AC/AC-Wandler,
- DC/AC-Wandler, insbesondere Pulswechselrichter, und
- DC/DC-Wandler.

Bei diesen Elektronikschaltungen ermöglicht eine genaue Messung des Stroms bzw. der Ströme eine sehr genaue Wandlung, und die Nutzung der Messanordnung hierfür hat sich als besonders vorteilhaft erwiesen.

Ein Fahrzeug weist mindestens eine solche Messanordnung oder mindestens eine solche Elektronikschaltung auf. Bevorzugt weist das Fahrzeug mindestens drei solche Messanordnungen auf. Bei Fahrzeugen kann die genaue Messung zu einer Reduzierung der Verlustleistung und damit zu einer vergrößerten Reichweite führen. Dies ist bei Fahrzeugen besonders vorteilhaft.

Weitere Einzelheiten und vorteilhafte Weiterbildungen der Erfindung ergeben sich aus den im Folgenden beschriebenen und in den Zeichnung dargestellten, in keiner Weise als Einschränkung der Erfindung zu verstehenden Ausführungsbeispielen sowie aus den Unteransprüchen. Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen. Es zeigt:
- Fig. 1: in schematischem Längsschnitt ein erstes Ausführungsbeispiel einer Messanordnung,
- Fig. 2: in schematischem Längsschnitt ein zweites Ausführungsbeispiel einer Messanordnung,
- Fig. 3: in einem Querschnitt durch eine Stromleitung eine erste Querschnittsfläche,
- Fig. 4: in einem Querschnitt durch eine Stromleitung eine zweite Querschnittsfläche,
- Fig. 5: in schematischem Längsschnitt ein drittes Ausführungsbeispiel einer Messanordnung,
- Fig. 6: in schematischem Längsschnitt ein viertes Ausführungsbeispiel einer Messanordnung, und
- Fig. 7: in schematischer Darstellung ein Fahrzeug mit einer Elektronikschaltung und mit einer Messanordnung.

Im Folgenden sind gleiche oder gleich wirkende Teile mit den gleichen Bezugszeichen versehen und werden üblicherweise nur einmal beschrieben. Die Beschreibung ist figurenübergreifend aufeinander aufbauend, um unnötige Wiederholungen zu vermeiden.

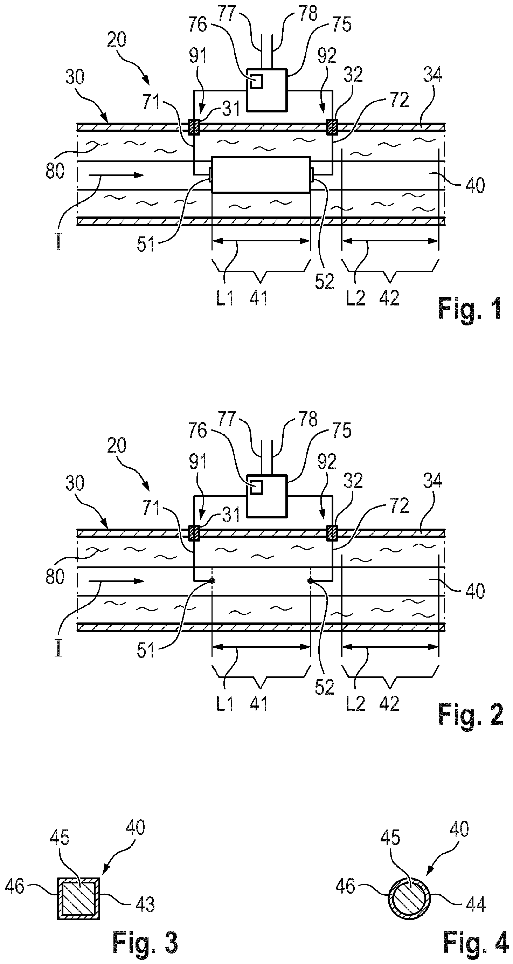

Fig. 1 zeigt eine Messanordnung 20 mit einer Stromleitung 40, einer ersten Messstelle 51, einer zweiten Messstelle 52, einem Kühlmittelkanal 30 und einem Kühlmittel 80.

Der Kühlmittelkanal 30 hat eine Kühlmittelkanalwand 34, und die Stromleitung 40 ist im Kühlmittelkanal 30 angeordnet.

Durch die Stromleitung 40, die bspw. als Stromschiene ausgebildet ist, kann ein Strom I fließen. Die erste Messstelle 51 und die zweite Messstelle 52 definieren zwischen sich einen Messabschnitt 41, und bei fließendem Strom I fällt im Messabschnitt 41 durch den elektrischen Widerstand in Messabschnitt 41 eine Spannung ab.

Die erste Messstelle 51 ist mit einer ersten Signalleitung 71 verbunden, und die zweite Messstelle 52 ist mit einer zweiten Signalleitung 72 verbunden. Die erste Signalleitung 71 erstreckt sich an einer Durchtrittsstelle 91 durch die Kühlmittelkanalwand 34, und die zweite Signalleitung 72 erstreckt sich an einer Durchtrittsstelle 92 durch die Kühlmittelkanalwand 34 hindurch. Bevorzugt sind an den Durchtrittsstellen 91, 92 Abdichtelemente 31, 32 vorgesehen, um einen Austritt des Kühlmittels 80 aus dem Kühlmittelkanal 30 zu verhindern oder zu verringern. Außerhalb des Kühlmittelkanals 30 sind die erste Signalleitung 71 und die zweite Signalleitung 72 mit einer Signalverarbeitungseinrichtung 75 verbunden, und zwei Signalleitungen 77, 78 sind mit der Signalverarbeitungseinrichtung 75 verbunden, um das in der Signalverarbeitungseinrichtung 75 erzeugte Signal auszugeben.

Die Signalverarbeitungseinrichtung 75 weist bevorzugt mindestens ein Schaltungselement 76 auf aus der Schaltungselementgruppe bestehend aus
- Verstärker,
- Analog-/Digitalwandler,
- Übertragungsmodul für eine drahtlose Datenübertragung, und
- Spannungsteiler.

Im Betrieb kann die Stromleitung 40 durch das Kühlmittel 80 gekühlt werden, und das Kühlmittel 80 ist bevorzugt fluidförmig, also flüssig und/oder gasförmig. Dies ermöglicht einen Kühlmittelfluss und damit einen guten Abtransport von Wärme über den Kühlmittelkanal 30.

Die Stromleitung 40 ist im Ausführungsbeispiel im Messabschnitt 41 als sogenannter Shunt ausgebildet. Ein Shunt ist ein niederohmiger elektrischer Widerstand.

Die Stromleitung 40 hat im Messabschnitt 41 bevorzugt einen höheren spezifischen elektrischen Widerstand als in mindestens einem ersten Stromleitungsabschnitt 42 außerhalb des Messabschnitts 41.

Der Messabschnitt 41 hat eine Länge L1 und der Stromleitungsabschnitt 42 hat eine Länge L2 entlang der Stromleitung 40. Wenn die Längen L1 und L2 gleich gewählt werden, hat die Stromleitung 40 bevorzugt im Messabschnitt 41 einen höheren elektrischen Widerstand als in dem außerhalb des Messabschnitts 41 vorgesehenen Stromleitungsabschnitt 42. Anders ausgedrückt ist der elektrische Widerstand pro Länge der Stromleitung 40 im Messabschnitt 41 größer als in zumindest einem Abschnitt der Stromleitung 40 außerhalb des Messabschnitts 41.

Die Stromleitung 40 besteht bspw. im ersten Stromleitungsabschnitt 42 aus Kupfer oder aus einer Kupferlegierung, und im Messabschnitt 41 besteht er bspw. aus Manganin, Isotan oder Isabellin oder aus einer Kupferlegierung mit größerem spezifischem elektrischem Widerstand.

Die Abdichtelemente 31, 32 sind bspw. ausgebildet als
- Verklebung,
- Gummimuffe,
- Lippendichtung, und/oder
- O-Ring-Dichtung.

Fig. 2 zeigt eine weitere Ausführungsform der Messanordnung 20.

Im Unterschied zum Ausführungsbeispiel von Fig. 1 weist die Stromleitung 40 im Messabschnitt 41 keinen besonderen Shunt auf, sondern die Stromleitung 40 ist im Messabschnitt 41 und außerhalb des Messabschnitts 41 bzw. insbesondere in einem Stromleitungsabschnitt 42 außerhalb des Messabschnitts 41 gleich ausgebildet. Die Stromleitung 40 hat also im Messabschnitt 41 und im Stromleitungsabschnitt 42 das gleiche Material und den gleichen Querschnitt.

Bei sehr hohen Strömen I ist es nicht erforderlich, einen höheren elektrischen Widerstand im Messabschnitt 41 vorzusehen, und auch bei guten Leitermaterialien wie Kupfer oder Kupferlegierung fällt bei hohen Strömen I im Messabschnitt 41 eine ausreichende Spannung ab.

In einer weiteren Ausführungsform kann der Querschnitt bzw. die Querschnittsfläche im Messabschnitt 41 verringert werden, um den elektrischen Widerstand im Messabschnitt 41 zu erhöhen.

Fig. 3 zeigt beispielhaft die Stromleitung 40 im Querschnitt. Die Stromleitung 40 hat eine Querschnittsfläche 43, und sie weist im Ausführungsbeispiel einen metallischen Kern 45 zum Leiten des Stroms I und eine Isolierung 46 auf, die übertrieben groß dargestellt ist. Durch die Isolierung 46 wird ein direkter Kontakt des Kühlmittels 80 mit dem metallischen Kern 45 verhindert und somit die Gefahr eines Kurzschlusses verringert. Die Isolierschicht 46 ist nicht zwingend erforderlich, und es kann als Kühlmittel 80 ein elektrisch schlecht leitendes Fluid verwendet werden.

Fig. 4 zeigt einen weiteren Querschnitt durch die Stromleitung 40, wobei wie bei Fig. 3 ein Metallkern 45 und eine Isolierschicht 46 vorgesehen sind. Der Querschnitt mit der Querschnittsfläche 44 hat beispielhaft hat eine runde Grundform, und die Querschnittsfläche 44 ist kleiner als die Querschnittsfläche 43 der Stromleitung 40 von Fig. 3.

Es kann bspw. im Messbereich 41 der runde Querschnitt von Fig. 4 und außerhalb des Messbereichs 41 der rechteckige Querschnitt von Fig. 3 vorgesehen sein. Sofern der Durchmesser der Querschnittsfläche 44 der Seitenlänge der Querschnittsfläche 43 entspricht, ist die Querschnittsfläche 44 kleiner als die Querschnittsfläche 43. Hierdurch wird der elektrische Widerstand im Messbereich 41 gegenüber dem Widerstand im Stromleitungsabschnitt 42, der die gleiche Länge wie der Messabschnitt 41 hat, erhöht, und in der Signalverarbeitungseinrichtung 75 kann eine größere Spannung ausgewertet und die Genauigkeit erhöht werden.

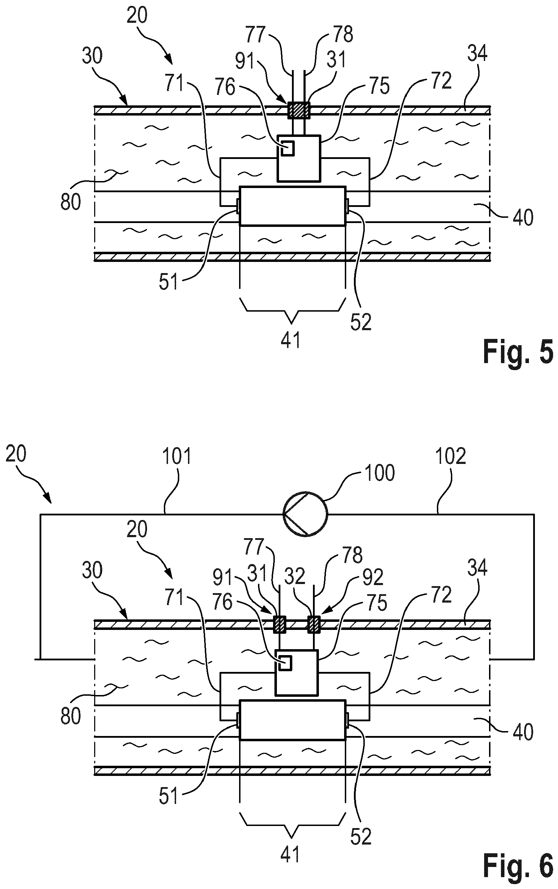

Fig. 5 zeigt eine weitere Ausführungsform der Messanordnung 20. Die Signalverarbeitungseinrichtung 75 ist in dieser Ausführungsform im Kühlmittelkanal 30 angeordnet, und sie kann dadurch durch das Kühlmittel 80 mit gekühlt werden. Von der Signalverarbeitungseinrichtung 75 gehen zwei Signalleitungen 77, 78 durch die Kühlmittelkanalwand 34 hindurch zur Außenseite des Kühlmittelkanals 30, um dort das durch die Signalverarbeitungseinrichtung 75 verarbeitete Messsignal bereitzustellen, welches beispielsweise in einem elektrischen Wandler benötigt wird. Die Signalleitungen 77, 78 werden an der Durchtrittsstelle 91 durch mindestens ein Abdichtelement 31 abgedichtet, um einen Austritt des Kühlmittels 80 an der Durchtrittsstelle 31 zu verhindern.

Fig. 6 zeigt eine weitere Ausführungsform der Messanordnung 20, bei der die Signalleitungen 77 und 78 an zwei unterschiedlichen Durchtrittsstellen 91, 92 durch die Kühlmittelkanalwand 34 hindurch treten.

Zudem ist schematisch eine Kühlmittelpumpe 100 dargestellt, welche über eine Kühlmittelleitung 101 Kühlmittel 80 zum Kühlmittelkanal 30 pumpen kann, und das Kühlmittel 80 kann anschließend über eine Kühlmittelleitung 102 zurück zur Pumpe 100 fließen. Dies ermöglicht einen Kühlmittelkreislauf und damit eine gute und effiziente Kühlung. Die Kühlmittelleitung 101 oder die Kühlmittelleitung 102 können zudem einen - nicht dargestellten - Kühlmittelkühler aufweisen, um Wärme vom Kühlmittel 80 abzuführen.

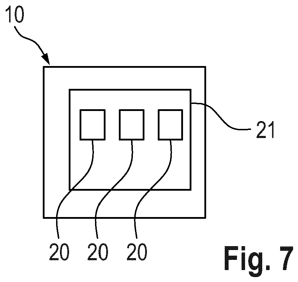

Fig. 7 zeigt in schematischer Darstellung eine Elektronikschaltung 21, welche mindestens eine Messanordnung 20 aufweist. Bevorzugt weist die Elektronikschaltung 21 wie dargestellt mindestens drei Messanordnungen 20 auf, um bei einem dreiphasigen Stromnetz in jedem Außenleiter den Strom messen zu können.

Die Elektronikschaltung weist bevorzugt mindestens eine erste Elektronikschaltung auf aus der Elektronikschaltungsgruppe bestehend aus:
- AC/DC-Wandler,
- AC/AC-Wandler,
- DC/AC-Wandler, und
- DC/DC-Wandler.

Bevorzugt handelt es sich um getaktete Wandler, und beim DC/AC-Wandler handelt es sich bevorzugt um einen gepulsten DC/AC-Wandler bzw. um einen Pulswechselrichter.

Bevorzugt hat ein Fahrzeug 10 eine solche Elektronikschaltung 21 bzw. zumindest eine solche Messanordnung 20 und bevorzugt mindestens drei Messanordnungen 20.

Naturgemäß sind im Rahmen der vorliegenden Anmeldung vielfältige Abwandlungen und Modifikationen möglich.

So können beispielsweise in dem Kühlmittelkanal mehrere bzw. mindestens zwei Stromleitungen verlaufen. Dies führt zu einer gleichmäßigen Kühlung und zu einer Verringerung des Gesamtgewichts.

Statt des Kühlmittelkanals kann eine Wanne genutzt werden, durch welche die Stromleitungen verlaufen.

## Patentansprüche

1. Messanordnung (20), welche eine Stromleitung (40), eine erste Messstelle (51), eine zweite Messstelle (52) und ein Kühlmittel (80) aufweist, welche erste Messstelle (51) an der Stromleitung (40) vorgesehen ist,
welche zweite Messstelle (52) an der Stromleitung (40) vorgesehen ist und von der ersten Messstelle (51) beabstandet ist, um eine Spannungsmessung der durch den durch die Stromleitung (40) fließenden Strom (I) entstehenden Spannung in einem Messabschnitt (41) der Stromleitung (40) zu ermöglichen, welcher Messabschnitt (41) zwischen der ersten Messstelle (51) und der zweiten Messstelle (52) definiert ist, und welches Kühlmittel (80) fluidförmig ist und zumindest bereichsweise in direktem Kontakt zur Stromleitung (40) im Bereich zwischen der ersten Messstelle (51) und der zweiten Messstelle (52) steht.

2. Messanordnung (20) nach Anspruch 1, bei welcher die Stromleitung (40) im Messabschnitt (41) einen größeren elektrischen Widerstand aufweist als in mindestens einem ersten Stromleitungsabschnitt (42) außerhalb des Messabschnitts (41), welcher erste Stromleitungsabschnitt (42) die gleiche Länge (L1, L2) entlang der Stromleitung (40) hat wie der Messabschnitt (41).

3. Messanordnung (20) nach Anspruch 2, bei welcher die Stromleitung (40) im Messabschnitt (41) zumindest abschnittsweise eine geringere Querschnittsfläche (43, 44) aufweist als in dem mindestens einen ersten Stromleitungsabschnitt (42).

4. Messanordnung (20) nach Anspruch 2 oder 3, bei welcher die Stromleitung (40) im Messabschnitt (41) zumindest abschnittsweise ein erstes Material aufweist und in dem mindestens einen ersten Stromleitungsabschnitt (42) zumindest abschnittsweise ein zweites Material aufweist, welches erste Material einen höheren spezifischen elektrischen Widerstand (p) aufweist als das zweite Material.

5. Messanordnung (20) nach Anspruch 1, bei welcher die Stromleitung (40) im Messabschnitt (41) zumindest abschnittsweise die gleiche Querschnittsfläche (43; 44) und das gleiche Material aufweist wie in mindestens einem zweiten Stromleitungsabschnitt (42) außerhalb des Messabschnitts (41).

6. Messanordnung (20) nach einem der vorhergehenden Ansprüche, welche einen Kühlmittelkanal (30) mit einer Kühlmittelkanalwand (34) aufweist, wobei im Kühlmittelkanal (30) das Kühlmittel (80) vorgesehen ist, und wobei der Messabschnitt (41) der Stromleitung (40) zumindest abschnittsweise im Kühlmittelkanal (30) angeordnet ist.

7. Messanordnung (20) nach Anspruch 6, bei welcher die Stromleitung (40) zumindest abschnittsweise außerhalb des Messabschnitts (41) im Kühlmittelkanal (30) angeordnet ist.

8. Messanordnung nach Anspruch 6 oder 7, bei welcher die erste Messstelle (51) mit einer ersten Signalleitung (71) verbunden ist und die zweite Messstelle (52) mit einer zweiten Signalleitung (72) verbunden ist, und bei welcher sich die erste Signalleitung (71) und die zweite Signalleitung (72) an mindestens einer ersten Durchtrittsstelle (91, 92) durch die Kühlmittelkanalwand (34) hindurch erstrecken, wobei mindestens ein erstes Abdichtelement (31, 32) zur Abdichtung der mindestens einen ersten Durchtrittsstelle (91, 92) vorgesehen ist.

9. Messanordnung (20) nach einem der Ansprüche 6 bis 8, welche eine Signalverarbeitungseinrichtung (75) aufweist, welche Signalverarbeitungseinrichtung (75) mit der ersten Messstelle (51) und mit der zweiten Messstelle (52) elektrisch verbunden ist, welche Signalverarbeitungsvorrichtung (75) sich zumindest abschnittsweise im Kühlmittelkanal (30) befindet.

10. Messanordnung (20) nach Anspruch 9, bei welcher die Signalverarbeitungseinrichtung (75) mindestens ein Schaltungselement (76) umfasst aus der Schaltungselementgruppe bestehend aus
- Verstärker,
- Analog-/Digitalwandler,
- Übertragungsmodul für eine drahtlose Datenübertragung, und
- Spannungsteiler.

11. Messanordnung (20) nach Anspruch 9 oder 10, bei welcher sich mindestens eine dritte Signalleitung (77, 78) von der Signalverarbeitungseinrichtung (75) an mindestens einer zweiten Durchtrittsstelle (31) durch die Kühlmittelkanalwand (34) hindurch erstreckt, wobei mindestens ein zweites Abdichtelement (31) zur Abdichtung der mindestens einen zweiten Durchtrittsstelle (91; 91, 92) vorgesehen ist.

12. Messanordnung (20) nach einem der vorhergehenden Ansprüche, welche zur Messung eines Stroms (I) in der Stromleitung (40) mit einer maximalen Stromstärke eingerichtet ist, welche maximale Stromstärke mindestens 10 A beträgt, bevorzugt mindestens 50 A beträgt und besonders bevorzugt mindestens 80 A beträgt.

13. Elektronikschaltung (21), welche mindestens eine Messanordnung (20) nach einem der vorhergehenden Ansprüche aufweist.

14. Elektronikschaltung (21) nach Anspruch 13, welche mindestens eine erste Elektronikschaltung aufweist aus der Elektronikschaltungsgruppe bestehend aus:
- AC/DC-Wandler,
- AC/AC-Wandler,
- DC/AC-Wandler, insbesondere Pulswechselrichter, und
- DC/DC-Wandler.

15. Fahrzeug (10), welches mindestens eine Messanordnung (20) nach einem der Ansprüche 1 bis 12 oder mindestens eine Elektronikschaltung nach Anspruch 13 oder 14 aufweist.
